Europäisches Patentamt

European Patent Office

Office européen des brevets

(11) Veröffentlichungsnummer: **0 502 247 A1**

# EUROPÄISCHE PATENTANMELDUNG

(21) Anmeldenummer: **91117781.4**

(22) Anmeldetag: **18.10.91**

(51) Int. Cl.⁵: **G06K 7/10, H01L 21/68**

(30) Priorität: **06.03.91 DE 4107069**

(43) Veröffentlichungstag der Anmeldung:
**09.09.92 Patentblatt 92/37**

(84) Benannte Vertragsstaaten:
**DE FR GB IT NL**

(71) Anmelder: **Leuze electronic GmbH + Co.**
**In der Braike 1**
**W-7311 Owen-Teck(DE)**

(72) Erfinder: **Spratte, Hans-Hermann, Dipl.-Ing.**
**Villastrasse 30**
**W-7312 Kirchheim/Teck(DE)**
Erfinder: **Aldiek, Norbert, Dipl.-Phys.Ing.**
**Göppinger Strasse 60**
**W-7311 Schlierbach(DE)**

(54) **Einrichtung zum Lesen von Strichkodierungen auf Halbleiteroberflächen.**

(57) 2.1. Bei einem bekannten derartigen Verfahren erfolgt das Lesen von Strichkodierungen auf Halbleiteroberflächen mit einem optischen Sende- / Empfangssystem, dessen optische Achsen zueinander einen Winkel von 180° - 2 Θ einschließen, wobei der Winkel Θ zwischen der Halbleiteroberfläche und der jeweiligen optischen Achse liegend definiert ist. Dabei ist nachteilig, daß die Lichtquelle inkohärentes Licht abstrahlt, so daß eine optische Filterung des Lichts zur Kontrastanhebung nichtmöglich ist, und daß Neigungen der Halbleiteroberfläche die Intensität des Empfangssignals beeinträchtigen. Das neue Verfahren schließt diese Nachteile aus.

2.2. Die Strichkodierung (14) auf der Halbleiteroberfläche (1) wird mit einem kohärenten Strahlenbündel (12) mit ebenen Wellenfronten abgetastet. Die nullte Beugungsordnung (17) des in der Brennebene (13') der Sende- / Empfangsoptik (2) entstehenden Ortsfrequenzspektrums (15) der beugenden Strichkodieiung (14) liegt im Zentrum der ersten Blende (4). Die zweite Blende ist in der Bildebene der von der Sende- / Empfangsopritk (2) abgebildeten Strichkodierung (14) räumlich vor dem fotosensitiven Lichtempfänger (6) angeordnet.

Fig. 1

Die Erfindung betrifft eine Einrichtung zum Lesen von Strichkodierungen auf Halbleiteroberflächen nach dem Oberbegriff des Patentanspruchs 1.

Eine derartige Einrichtung ist durch die US-PS 45 85 931 bekannt. Bei dieser Einrichtung erfolgt das Lesen von Strichkodierungen auf Halbleiteroberflächen mit einem optischen Sende- / Empfangssystem, deren optische Achsen zueinander einen Winkel von 180° - 2 Θ einnehmen, wobei der Winkel Θ zwischen der Halbleiteroberfäche und der jeweiligen optischen Achse aufgespannt ist. Der Winkel Θ soll über einen Bereich von ungefähr 30° bis 60° wählbar sein. Hierbei strahlt eine nicht näher bezeichnete Lichtquelle ein Lichtbündel unter dem Winkel Θ auf die Halbleiteroberfläche. Dieses Lichtbündel wird an der polierten Oberfläche bzw. im Bereich der Lücken der Strichkodierung unter dem Winkel Θ reflektiert und gelangt über eine Linse sowie ein Blendensystem auf einen Fotodetektor. Mit dem im Fotodetektor generierten Fotostrom wird ein Verstärker beaufschlagt, dessen Ausgangssignal einem Dekoder zugeführt und im Anschluß daran das Dekodierungsergebnis mittels Display angezeigt wird.

Durch Rotation der Halbleiterscheibe wird die Strichkodierung unter dem Sende- / Empfangssystem vorbeibewegt. Dieses bedeutet, daß zeitweise das Sendelicht an den Mikrorauheiten der Striche gestreut wird.

Nachteilig ist dabei, daß das Blendensystem einschließlich Linse auf der Empfangsseite nur eine kleine Apertur aufweist. Daher gelangt im Bereich der Mikrorauheit kein oder nur wenig Licht auf den Fotodetektor. Außerdem strahlt die Lichtquelle inkohärentes Licht ab, so daß eine optische Filterung des Lichts zur Kontrastanhebung nicht möglich ist, ferner beeinträchtigen Neigungen der Halbleiteroberfläche die Intensität des Empfangssignals.

Der Erfindung liegt die Aufgabe zugrunde, durch eine optische Filterung des Lichts eine Kontraststeigerung zu erzielen und sich auf die Intensität des Empfangssignals auswirkende Neigungen der Halbleiteroberflächen auszuschließen.

Diese Aufgabe ist erfindungsgemäß durch die kennzeichnenden Merkmale des Anspruchs 1 gelöst.

Weiterbildungen und Zweckmäßige Ausgestaltungen der Erfindung sind in den Unteransprüchen charakterisiert.

Die Erfindung wird im nachstehenden anhand der Zeichnung erläutert.

Es zeigen:

Fig. 1 Beleuchtungs- und Abbildungsstrahlengang in schematischer Darstellung,

Fig. 2 eine perspektivische Ansicht der Anordnung Strichkodierung, Optik, Filterblende, abgebildete und gefilterte Strichkodierung,

Fig. 3 die veranschaulichte Wirkung der Rechteckblende beim Lesen der Strichkodierung,

Fig. 4 eine konkrete An- und Zuordnung der im Beleuchtungs- und Abbildungsstrahlengang befindlichen Bauelemente,

Fig.5a) das Beugungsbild mit Detektionssignal bei idealer Lage der Halbleiteroberfläche,

Fig.5b) das Beugungsbild mit Detektionssignal bei geneigter Halbleiteroberfläche,

Fig.5c) die drei Möglichkeiten zur Korrektur des Beugungsbildes in das Zentrum der Filterblende wie bei Figur 5a.

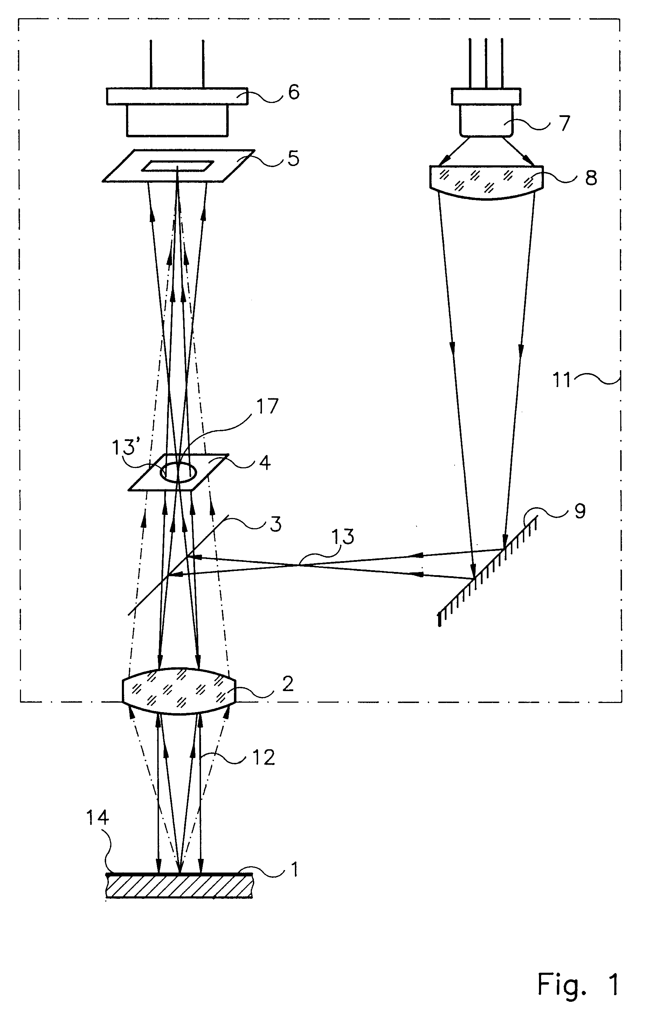

In Fig. 1 ist mit (7) eine Laserstrahlquelle in Form einer Laserdiode dargestellt, die ein kohärentes Lichtbündel divergent abstrahlt. Die Wellenlänge dieser Laserstrahlquelle (7) liegt vorzugsweise in einem Bereich, in denen nicht die Empfindlichkeit einer auf die Halbleiteroberfläche (1) aufgebrachten Fotoresistschicht liegt.

Das Licht der Laserstrahlquelle (7) wird mittels Fokussieroptik (8) und nach Umlenkung mit Umlenkspiegel (9) in den Brennpunkt (13) der Sende- / Empfangsoptik (2) fokussiert, so daß sich hinter der Sende- / Empfangsoptik (2) ein paralleles Strahlenbündel (12) einstellt, welches als kohärente Wellenfront auf die Halbleiteroberfläche (1) fällt. Zwischen Brennpunkt (13) und Sende- / Empfangsoptik (2) befindet sich ein Strahlungsteilerspiegel (3).

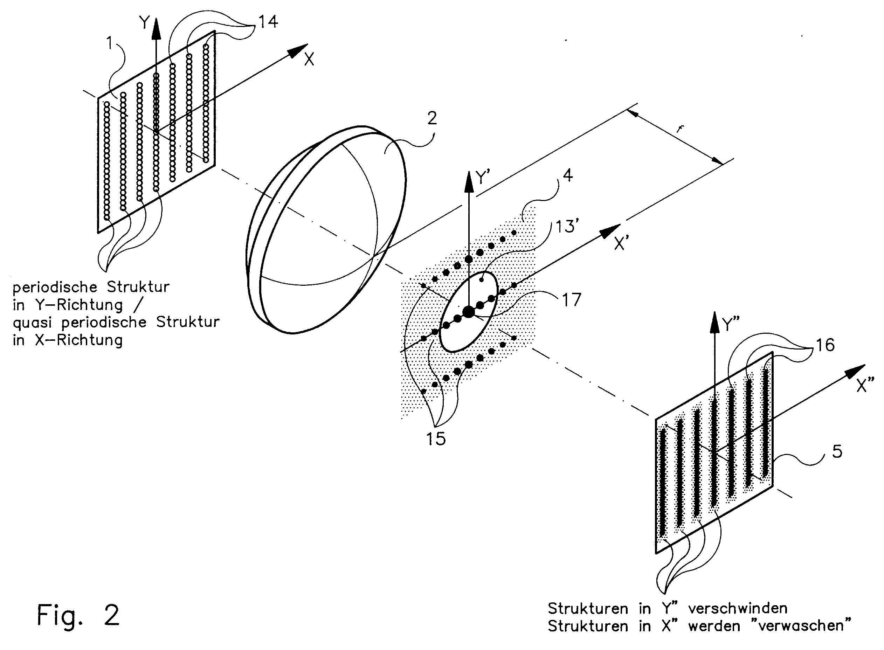

Auf der Halbleiteroberfläche (1) ist eine Strichkodierung (14) aufgebracht, die vorzugsweise durch Laserbeschuß mittels frequenzverdoppeltem Nd-YAG-Laser erzeugt wird und zwar derart, daß eine Reihe sich überlappender Softmark-Schmelzpunkte zu einem Strich ausgebildet wird. Die auf die Strichkodierung (14) fallende kohärente Wellenfront wird dort reflektiert und erfährt sowohl eine Phasen- als auch eine Amplitudenmodulation. Dieses in Amplitude und Phase veränderte Licht wird von der Sende- / Empfangsoptik (2) aufgefangen und zur Abbildung gebracht, wobei in der bildseitigen Brennebene (13') das Ortsfrequenzspektrum (15) (Fourierspektrum) der beugenden Strichkodierung (14) entsteht (siehe hierzu Fig. 2).

In dieser Brennebene (13'), die auch als Fourierebene bezeichnet wird, wird durch den Einbau einer Blende das Ortsfrequenzspektrum (15) und damit das Bild verhindert. Der Einbau einer kreisförmigen Lochblende (4) zentrisch zur nullten Beugungsordnung (17) hat die Eigenschaft einer Tiefpaßfilterung. Dieses bedeutet, daß höherfrequente Anteile des Ortsfrequenzspektrums (15) abgeblockt werden und damit nicht auf die Fotodiode (6) gelangen. Das ortsfrequenzgefilterte Licht gelangt dann über eine Rechteckblende (5) auf die Fotodiode (6).

Das Ausgangssignal der Fotodiode (6) wird einem nicht dargestellten Verstärker (22) zugeführt und anschließend von einer Auswerteeinheit dekodiert.

Fig. 2 zeigt die Funktion und Wirkungsweise der Ortsfrequenzfilterung im Empfangsstrahlengang. Auf der Halbleiteroberfläche (1) ist die Strichkodierung (14) aufgebracht, wobei die Strichrichtung parallel zur Y-Achse verläuft. Das an der Strichkodierung (14) gebeugte Licht wird mittels Sende- / Empfangsoptik (2) gesammelt und erscheint in der Brennebene (13') als Ortsfrequenzspektrum (15). Im Koordinatenursprung (X' = 0, Y' = 0) liegt die nullte Beugungsordnung (17) und gleichzeitig das Zentrum der Filterblende (4). Durch den Lochdurchmesser der Filterblende (4) wird die Grenzfrequenz des noch durchgelassenen Ortsfrequenzspektrums definiert. Es erscheint daher auf der Rechteckblende (5) ein gefiltertes Bild mit der abgebildeten Strichkodierung (16). Durch diese Filtermethode wird eine Kontraststeigerung erreicht.

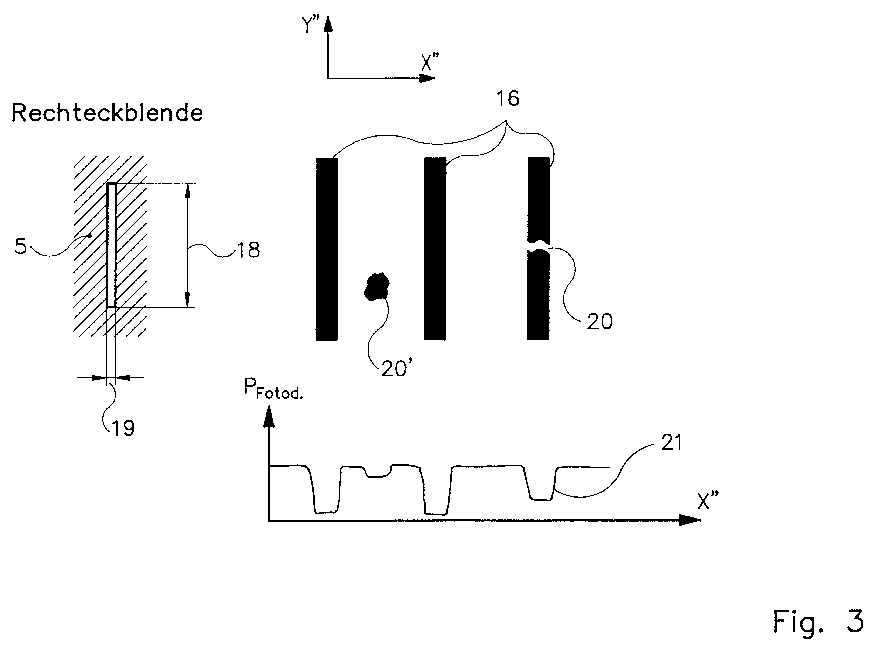

Die Wirkung der Rechteckblende (5) zeigt Fig. 3. Die Rechteckblende (5) hat eine Öffnung mit einem Verhältnis Schmal- (19) zur Breitseite (18) von typischerweise 1 : 40 bis 1 : 80, wobei dieses Verhältnis von der Geometrie der Strichkodierung (14) und dem Abbildungsmaßstab der Sende- / Empfangsoptik (2) abhängt. Auf dieser Rechteckblende erscheint die Abbildung (16) der Strichkodierung (14). Wird nun der Sensor (11) (siehe auch Fig. 1) relativ zur Halbleiteroberfläche (1) in -X-Richtung bewegt, so wandert die Abbildung (16) in X''-Richtung über die Rechteckblende (5). Es erfolgt damit eine integrale Detektorbewertung mittels Fotodiode (6) und zwar in Strichrichtung. Wie die detektierte Lichtleistung (21) als Funktion des Ortes X'' zeigt, gehen durch diese integrale Bewertung kleinere Störungen (20, 20') in der Abbildung (16) nicht in das Ausgangssignal der Fotodiode (6) ein.

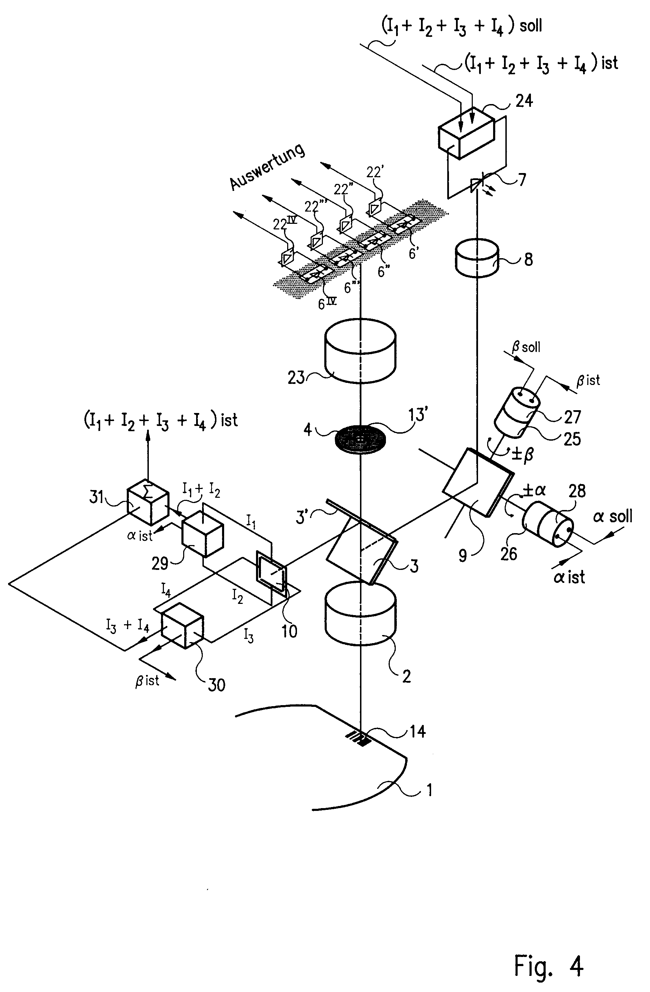

Fig. 4 zeigt die weitere Ausgestaltung der Erfindung und zwar derart, daß

a) die Neigung der Halbleiteroberfläche (1) in gewissen Grenzen automatisch kompensiert wird,

b) gleichzeitig mehrere Scanspuren mittels der Fotodioden 6' bis $6^{IV}$ abgetastet werden und

c) das Ausgangssignal der Fotodiode (6) unabhängig von der Lichtleistung derart nachgeregelt wird, daß das Ausgangssignal auch bei schlecht reflektierender Halbleiteroberfläche (1) eine ausreichende Amplitude aufweist.

Die in Fig. 4 dargestellte Anordnung entspricht bis auf Einzelheiten der Anordnung nach Fig. 1. Zu diesen Einzelheiten gehört der in den beiden Drehachsen $\alpha$ und $\beta$ beweglich angeordnete Umlenkspiegel (9), wobei die beiden Drehachsen ($\alpha$, $\beta$) senkrecht aufeinander stehen und der Drehachsenschnittpunkt in der Bildebene der Sende- / Empfangsoptik (2) liegt. Angetrieben wird der Umlenkspiegel (9) über den Aktuator (26) für die Drehachse $\pm \alpha$ und den Aktuator (25) für die Drehachse $\pm \beta$. Den Aktuatoren (25, 26) sind die jeweiligen Regelelektroniken (27) und (28) zugeordnet.

Als weitere Einzelheit ist in Fig. 4 der Strahlungsteilerspiegel (3'), die zweidimensionale positionsempfindliche Fotodiode (10), die beiden Auswerteverstärker (29) und (30) für $\alpha_{ist}$ und $\beta_{ist}$ und der Summationsverstärker (30) dargestellt.

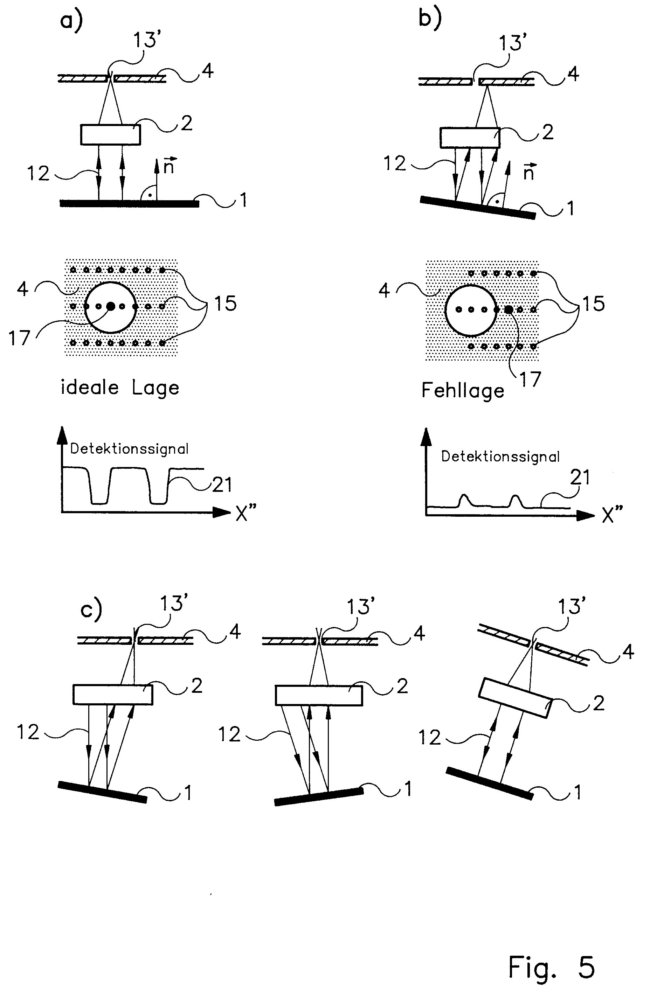

Die Funktionsweise dieser beiden ersten Einzelheiten ist folgendermaßen: Bei zu großer Neigung der Halbleiteroberfläche (1) und $\alpha = o$, $\beta = 0$ erfolgt eine seitliche Verschiebung des Ortsfrequenzspektrums (15) in der Brennebene (13'). Dieses kann dazu führen, daß die nullte Beugungsordnung (17) (siehe auch Fig. 5) nicht mehr durch die Öffnung der Filterblende (4) gelangt, was aber bezüglich des Ausgangssignals der Fotodiode (6) unerwünscht ist. Nun wird aber diese seitliche Verschiebung nach Auskopplung eines lichtleistungsmäßigen Bruchteils aus dem Ortsfrequenzspektrum (15) mittels des Strahlungsteilerspiegels (3') auf eine zweidimensionale positionsempfindliche Fotodiode (10) gelenkt, um das gleiche Bild des Ortsfrequenzspektrums (15) auf der Positionsdiode (10) abzubilden. Die Ebene des Strahlungsteilerspiegels 3' kann, soweit seine Funktion noch gewährleistet ist, eine beliebige Lage aufweisen. In den beiden nachgeschalteten Auswerteverstärkern (29, 30) wird die seitliche Verschiebung durch $\alpha_{ist}$ und $\beta_{ist}$ ermittelt und als Istgröße auf die jeweilige Regelelektronik (28) und (27) gegeben. Diese Regelelektronik ermittelt die Differenz zwischen Soll- und Istwert und gibt dann die entsprechende Stellgröße an den jeweiligen Aktuator (26, 25), der dann den Umlenkspiegel (9) soweit verstellt, bis die nullte Beugungsordnung (17) im Zentrum der Öffnung der Filterblende (4) liegt.

Die dritte zusätzliche Einzelheit in Fig. 4 ist der Summationsverstärker (31) und die Regelelektronik (24) zur Ansteuerung der Laserstrahlquelle (7). Hiermit wird erreicht, daß auch bei beträchtlichen Reflexionsgradschwankungen auf der Halbleiteroberfläche (1) das Ausgangssignal der Fotodiode (6) nahezu konstant bleibt. Gelöst ist dieser Vorgang durch die Regelelektronik (24), die eine mögliche Differenz zwischen Soll- und Istwert ermittelt und dann diese Stellgröße zum Nachregeln der Laserstrahlquelle (7) verwendet.

Die vierte und letzte zusätzliche Einzelheit in Fig. 4 ist die Aufspaltung der Fotodiode (6) in mehrere Einzeldioden (1..n) und zwar sind hier z. B. vier Fotodioden (6') bis ($6^{IV}$) skizziert, deren Ausgänge jeweils mit den Verstärkern (22') bis (22$^{IV}$) verbunden sind. Diese Ausgestaltung erlaubt das gleichzeitige mehrspurige Abtasten der Strichkodierung (14) bei einem Scanvorgang.

Fig. 5 zeigt mögliche Verschiebungen des Fourierspektrums (15) und die Wirkungsweise bei Korrektur bzw. Zurückschiebung in die "ideale Lage". Bei Fig. 5a) verläuft das Sendestrahlbündel (12) parallel zur Flächennormalen n der Halbleiteroberfläche (1). Damit ist gewährleistet, daß die nullte Beugungsordnung (17) im Öffnungsmittelpunkt der Filterblende (4) liegt. Dagegen zeigt Fig. 5b) die Neigung der Flächennormalen n gegenüber dem Sendestrahlbündel (12) und man sieht deutlich, daß die nullte Beugungsordnung (17) außerhalb der Öffnung der Filterblende (4) liegt. Dieses bedeutet, daß sich das Detektionssignal (21) am Ausgang der Fotodiode (6) umkehrt, was aber für die nachgeschaltete Auswerteeinheit ungünstig ist.

Fig. 5c) zeigt drei Möglichkeiten zur Korrektur der Lage der nullten Beugungsordnung (17) derart, daß sie im Öffnungsmittelpunkt der Filterblende (4) liegt. Links in Fig. 5c) wird zur Korrektur die Filterblende (4) verschoben, in der Mitte wird das nach Fig. 4 skizzierte Schwenken des Umlenkspiegels (9) angedeutet und rechts wird das Nachführen des vollständigen Sensorgehäuses (11) gezeigt.

| | |
|---|---|
| 1 | Halbleiteroberfläche |
| 2 | Sende- / Empfangsoptik (Kollimator) |
| 3 | Strahlteilerspiegel |
| 4 | Bildfeldblende Blende zur Filterung im Ortsfrequenzspektrum |
| 5 | Blende mit rechteckförmiger Öffnung |
| 6 | Fotodiode |
| 7 | Laserstrahlquelle |
| 8 | Fokussieroptik |
| 9 | Umlenkspiegel |
| 10 | Zweidimensionale positionsempfindliche Fotodiode |
| 11 | Sensorgehäuse |
| 12 | Paralleles und kohärentes Strahlenbündel |
| 13 | Brennpunkt der Sende- / Empfangsoptik (2) |
| 14 | Strichkodierung mit Feinstrukturierung auf der Halbleiteroberfläche (1) |
| 15 | Fourier- bzw. Ortsfrequenzspektrum in der Brennebene (13') |
| 16 | Abbildung der Strichkodierung (14) auf der Rechteckblende (5) |
| 17 | O.-Beugungsordnung in der Brennebene (13') |
| 18 | Breitseite der Blende (5) |
| 19 | Schmalseite der Blende (5) |
| 20 | Lücke (Störung) in der Abbildung (16) der Strichkodierung (14) |
| 20' | Prozeßbedingte Störung in der Lücke zwischen Strichen auf der Abbildung (16) der Strichkodierung (14) |
| 21 | Von der Fotodiode (6) detektierte Lichtleistung als Funktion der Ortskoordinate X" |
| 22 | Verstärker des Ausgangssignals der Fotodiode (6) |
| 23 | Tubussystem im Empfangsstrahlengang |
| 24 | Regelelektronik zur Ansteuerung der Laserstrahlquelle (7) |
| 25 | Aktuator ($\beta$) zur Drehung des Spiegels (9) um die $\beta$-Achse |
| 26 | Aktuator ($\alpha$) zur Drehung des Spiegels (9) um die $\alpha$-Achse |
| 27 | Regelelektronik für $\beta$-Achse |
| 28 | Regelelektronik für die $\alpha$-Achse |
| 29 | Auswerteverstärker für $\alpha_{ist}$ |
| 30 | Auswerteverstärker für $\beta_{ist}$ |
| 31 | Summationsverstärker $I_1 + I_2 + I_3 + I_4$ |

**Patentansprüche**

1. Einrichtung zum Lesen von auf der polierten Oberfläche von Halbleiterscheiben angebrachten Strichkodierungen mit Hilfe eines optischen Sende-Empfangssystems und einer elektronischen Verstärkeranordnung, wobei das Sendesystem eine Laserstrahlquelle, eine Kollimatoroptik, einen Umlenkspiegel und einen Strahlungsteilerspiegel aufweist und das Empfangssystem eine Fotodiode, zwei an verschiedenen Orten positionierte Blenden, den mit dem Sendestrahlengang gemeinsam genutzten Strahlungsteilerspiegel und einen Teil der sendeseitigen Kollimatoroptik enthält und die Verstärkeranordnung mit einer regelbaren Analogelektronik ausgerüstet ist, dadurch gekennzeichnet, daß die Strichkodierung (14) auf der Halbleiteroberfläche (1) mit einem kohärenten Strahlenbündel (12) mit ebenen Wellenfronten abgetastet wird und die nullte-Beugungsordnung (17) des in der Brennebene (13') der Sende / Empfangsoptik (2) entstehenden Ortsfrequenzspektrums (15) der beugenden Strichkodierung (14) im Zentrum der ersten Blende (4) liegt und die zweite Blende (5) in der Bildebene der von der Sende / Empfangsoptik (2) abgebildeten Strichkodierung (14) räumlich vor dem fotosensitiven Lichtempfänger (6) angeordnet ist.

2. Einrichtung nach Anspruch 1, dadurch gekennzeichnet, daß die erste Blende (4) vorzugsweise als kreisförmiges und achszentrales Loch mit definiertem Durchmesser ausgebildet ist und die zweite Blende (5) eine Rechteckblende ist, deren Verhältnis von Schmal- (19) zur Breitseite (18) sich typischerweise wie 1 : 40 bis 1 : 80 verhält, wobei dieses Verhältnis von der Geometrie der Strichkodierung (14) auf der Halbleiteroberfläche (1) und dem Abbildungsmaßstab der Sende- / Empfangsoptik (2) bestimmt wird.

3. Einrichtung nach Anspruch 1 oder 2, dadurch gekennzeichnet, daß die Breitseite (18) der zweiten Blende (5) parallel zur Längsrichtung der Strichkodierung (14) auf der Halbleiteroberfläche angeordnet ist.

4. Einrichtung nach einem der vorhergehenden Ansprüche, dadurch gekennzeichnet, daß zur selbsttätigen Korrektur einer seitlichen Verschiebung der nullten-Beugungsordnung (17) des Ortsfrequenzspektrums (15) zwischen der Ebene der Blende (4) und der Empfangsoptik (2) ein Strahlungsteilerspiegel (3') vorgesehen ist, der einen lichtleistungsmäßigen Bruchteil aus dem Ortsfrequenzspektum (15) auf eine zweidimensionale positionsempfindliche Fotodiode (10) lenkt, der zwei Auswerteverstärker (29, 30) für die Ausgangsströme nachgeschaltet sind, die die seitliche Verschiebung $\alpha_{ist}$ und $\beta_{ist}$ der nullten Beugungsordnung aus der Sollposition, die durch die Lage der Blende (4) gegeben ist, ermitteln und als Istwerte einer Regelelektronik (27, 28) zuführen, in der jeweils die Differenz zwischen Soll- und Istwert erfaßt und als Stellgröße dem zugeordneten, den Umlenkspiegel (9) betätigenden Aktuator (25, 26) zugeführt wird.

5. Einrichtung nach Anspruch 4, dadurch gekennzeichnet, daß der Umlenkspiegel (9) um zwei senkrecht aufeinanderstehenden Drehachsen mit den Drehwinkeln $\alpha$ und $\beta$ frei beweglich ist, wobei der Schnittpunkt der beiden Drehachsen in der Bildebene der Sende / Empfangsoptik (2) liegt.

6. Einrichtung nach einem der vorhergehenden Ansprüche, dadurch gekennzeichnet, daß die Apertur der Sende/ Empfangsoptik (2) den Winkelbereich für die Schwankung der Flächennormalen ⁻ der Halbleiteroberfläche bestimmt.

7. Einrichtung nach einem der vorhergehenden Ansprüche, dadurch gekennzeichnet, daß die Laserstrahlquelle (7) eine Laserdiode ist, die Licht ausreichender Kohärenzlänge in einem Wellenbereich abstrahlt, der außerhalb der Empfindlichkeit typischer auf Halbleiterobelflächen (1) aufgebrachter Fotoresistschichten liegt.

8. Einrichtung nach einem der vorhergehenden Ansprüche, dadurch gekennzeichnet, daß das fotosensitive Element (6) aus einer großflächigen PN- oder PIN-Diode auf Silizium-Basis besteht.

9. Einrichtung nach einem der vorhergehenden Ansprüche, dadurch gekennzeichnet, daß das fotosensitive Element (6) aus einem Fotodioden- oder CCD-Array besteht, dessen getrennte fotoempfindliche Flächen derart angeordnet sind, daß die Strichkodierung (14) gleichzeitig auf getrennten Scanspuren detektierbar ist.

Fig. 1

Y

1

14

X

2

f

Y'

4

13'

X'

17

periodische Struktur
in Y—Richtung /
quasi periodische Struktur
in X—Richtung

15

Y"

16

X"

5

Fig. 2

Strukturen in Y" verschwinden
Strukturen in X" werden "verwaschen"

EP 0 502 247 A1

Rechteckblende

Fig. 3

EP 0 502 247 A1

$(I_1 + I_2 + I_3 + I_4)$ soll

$(I_1 + I_2 + I_3 + I_4)$ ist

24

Auswertung

22'

22''

22'''

22$^{IV}$

7

6'

6''

6'''

6$^{IV}$

8

23

$\beta$ soll

$\beta$ ist

27

25

13'

4

$\pm\beta$

$(I_1 + I_2 + I_3 + I_4)$ ist

31

$I_1 + I_2$

$\pm\alpha$

28

$\alpha$ soll

$\alpha$ ist

29

26

9

$I_1$

3'

3

$I_4$

$I_2$

10

$I_3 + I_4$

$I_3$

2

$\beta$ ist

30

14

1

Fig. 4

Fig. 5

**EUROPÄISCHER RECHERCHENBERICHT**

Nummer der Anmeldung

| EINSCHLÄGIGE DOKUMENTE | | | EP 91117781.4 |
|---|---|---|---|
| Kategorie | Kennzeichnung des Dokuments mit Angabe, soweit erforderlich, der maßgeblichen Teile | Betrifft Anspruch | KLASSIFIKATION DER ANMELDUNG (Int. Cl⁵) |
| A | DE - A - 3 418 753 (GCA CORP.) * Anspruch 1; Fig. 1 * -- | 1 | G 06 K 7/10 H 01 L 21/68 |
| A | DE - A - 3 736 288 (LEUZE) * Anspruch 1; Fig. 1 * -- | 1 | |
| A | US - A - 4 794 238 (HAMPTON) * Anspruch 1; Fig. 1 * -- | 1 | |
| A | US - A - 4 825 093 (KIRISEKO et al.) * Zusammenfassung; Fig. 1 * -- | 1 | |
| A | US - A - 4 896 034 (KIRISEKO et al.) * Anspruch 1; Fig. 1 * ---- | 1 | |
| | | | RECHERCHIERTE SACHGEBIETE (Int. Cl⁵) |
| | | | G 06 K H 01 L |

Der vorliegende Recherchenbericht wurde für alle Patentansprüche erstellt.

| Recherchenort | Abschlußdatum der Recherche | Prüfer |
|---|---|---|
| WIEN | 12-06-1992 | MIHATSEK |